# FASCICULE DE BREVET EUROPEEN

(11) **EP 2 936 573 B1**
(45) Date de publication et mention de la délivrance du brevet: **25.03.2020**
(21) Numéro de dépôt: 13814895.2
(22) Date de dépôt: 19.12.2013
(51) Int. Cl.: H01L 35/08, H01L 35/32, H01L 35/10

(54) **ENSEMBLE COMPRENANT UN ÉLÉMENT THERMO ÉLECTRIQUE ET UN MOYEN DE CONNEXION ÉLECTRIQUE DUDIT ÉLÉMENT THERMO ÉLECTRIQUE, MODULE ET DISPOSITIF THERMO ÉLECTRIQUE COMPRENANT UN TEL ENSEMBLE**
ANORDNUNG MIT EINEM THERMOELEKTRISCHEN ELEMENT UND VORRICHTUNG ZUM ELEKTRISCHEN ANSCHLUSS DIESES THERMOELEKTRISCHEN ELEMENTS SOWIE THERMOELEKTRISCHES MODUL UND THERMOELEKTRISCHE VORRICHTUNG MIT SOLCH EINER ANORDNUNG
ASSEMBLY COMPRISING A THERMOELECTRIC ELEMENT AND A MEANS FOR ELECTRICALLY CONNECTING SAID THERMOELECTRIC ELEMENT, MODULE AND THERMOELECTRIC DEVICE COMPRISING SUCH AN ASSEMBLY

(30) Priorité: 20.12.2012 FR 1262441
(43) Date de publication de la demande: 28.10.2015
(73) Titulaire: Valeo Systemes Thermiques, 78320 Le Mesnil Saint Denis (FR)
(72) Inventeur: DE VAULX, Cédric, F-78770 Autouillet (FR)
(74) Mandataire: Metz, Gaëlle
(86) Numéro de dépôt international: PCT/EP2013/077328
(87) Numéro de publication internationale: WO 2014/096160

(56) Documents cités:
- EP-A1- 1 721 880
- WO-A2-2011/102498
- US-A1- 2005 002 818

## Description

La présente invention concerne un ensemble comprenant un élément thermo électrique et un moyen de connexion électrique dudit élément thermo électrique. Elle concerne aussi un module thermo électrique, notamment destiné à générer un courant électrique dans un véhicule automobile, comprenant ledit ensemble et un dispositif thermo électrique comprenant ledit module.

Actuellement, il a déjà été proposé des modules thermo électriques utilisant des éléments, dits thermo électriques, permettant de générer un courant électrique en présence d'un gradient de température entre deux de leurs faces opposées, dites première et deuxième faces de contact, selon le phénomène connu sous le nom d'effet Seebeck. Ces dispositifs comprennent un empilement de premiers tubes, destinés à la circulation des gaz d'échappement d'un moteur, et de seconds tubes, destinés à la circulation d'un fluide caloporteur d'un circuit de refroidissement. Les éléments thermo électriques sont pris en sandwich entre les tubes de façon à être soumis à un gradient de température provenant de la différence de température entre les gaz d'échappement, chauds, et le fluide de refroidissement, froid.

Les éléments thermo électriques sont groupés par paire. Les éléments thermo électriques appartenant à une même paire sont reliés entre eux électriquement par des pistes électriques disposées sur leurs premières ou sur leurs deuxièmes faces de contact.

Il est connu d'assembler les éléments thermo électriques aux pistes électriques par un procédé de brasage. Pendant ce procédé, les pistes électriques et les éléments thermo électriques en métal sont amenés à s'étendre sous l'effet de la température avant que la solidarisation ne s'effectue. Une fois que les pistes électriques ont atteint la bonne température, la solidarisation se réalise et on refroidit l'ensemble.

Un inconvénient vient du fait que les pistes électriques et les éléments thermo électriques ne présentent pas le même coefficient de dilatation thermique. Ainsi les pistes électriques se rétractent davantage que les éléments thermo électriques pendant le refroidissement, ce qui risque d'endommager les éléments thermo électriques, notamment en créant des fissures et/ou des cassures au niveau de leurs faces de contact.

Ce risque existe également, lorsque le module thermo électrique en fonctionnement est soumis à une forte différence de température entre son côté froid et son côté chaud, ce qui est typiquement le cas quand la face chaude du dispositif est soumise à des températures supérieures à 250°C. En atteignant ces températures, les pistes électriques solidarisées aux éléments thermo électriques côté chaud se dilatent davantage que celles solidarisées aux éléments thermo électriques côté froid, ce qui risque d'endommager les éléments thermo électriques de la même manière que décrite précédemment. Les documents EP1721880, US2005/0002818 et WO2011/102498 décrivent des modules thermo électriques.

L'invention vise à améliorer la situation.

L'invention propose ainsi un ensemble selon la revendication 1.

Grâce à l'invention, lorsque l'ensemble est soumis à de fortes variations de température, les premier et deuxième éléments déformables peuvent suivre d'une part la déformation du moyen de connexion et d'autre par la déformation de l'élément thermo électrique. Lorsque le moyen de connexion électrique et l'élément thermo électrique se contractent et se dilatent de façon différente, le moyen de liaison déformable amortit alors ces variations.

En rendant indépendante la déformation de la première face vis-à-vis de celle de la deuxième face, et inversement, on découple mécaniquement la contraction et la dilatation du moyen de connexion électrique par rapport à celles de l'élément thermo électrique. Le risque de casse ou de fissure entre le moyen de connexion électrique et l'élément thermo électrique est ainsi limité.

Les première et deuxième faces du premier élément sont reliées entre elles par deux parois latérales de sorte que le premier élément forme un tube, notamment à faces planes. Les faces latérales peuvent se déformer pour suivre d'une part les déformations de la première face du premier élément et d'autre part les déformations de la deuxième face du premier élément.

Le premier élément est une grille. La grille peut se déformer localement pour encaisser les contraintes de dilatation différentielle entre le moyen de connexion et l'élément thermo électrique.

Avantageusement, la grille présente une épaisseur comprise entre 50 et 300 µm.

Selon un aspect de l'invention, le premier élément est en métal de manière avantageuse, en aluminium.

Selon un aspect de l'invention, le deuxième élément est déformable plastiquement et/ou élastiquement.

Avantageusement, le deuxième élément remplit un volume délimité par la première face, la deuxième face et les faces latérales du premier élément. Le deuxième élément se déforme ainsi avec la première face du premier élément d'une certaine manière pour suivre la déformation du moyen de connexion et avec la deuxième face du premier élément d'une autre manière pour suivre la déformation de l'élément thermo électrique. Dans le cas d'un tube, il s'adapte à la forme que prend le tube.

Selon un aspect de l'invention, le deuxième élément est en un matériau non-brasable.

Selon un aspect de l'invention, le deuxième élément est en graphite. De manière avantageuse, le deuxième élément est une feuille de graphite d'épaisseur inférieure à 1 mm.

Selon un aspect de l'invention, ledit premier élément déformable est brasé audit élément thermo électriques et/ou audit moyen de connexion électrique.

Selon un aspect de l'invention, l'ensemble comporte un deuxième élément thermo électrique, présentant deux faces de contact, ladite deuxième face dudit premier élément étant également liée audit deuxième élément thermo électrique.

L'invention concerne aussi un module thermo électrique comprenant une pluralité d'ensembles tels que décrits précédemment.

L'invention concerne également un dispositif thermo électrique, notamment destiné à générer un courant électrique dans un véhicule automobile, comprenant au moins un module tel que décrit précédemment.

Les figures annexées feront bien comprendre comment l'invention peut être réalisée. Sur ces figures, des références identiques désignent des éléments semblables.
La figure 1 illustre en perspective, un exemple de dispositif thermo électrique conforme à l'invention, représenté de façon éclatée ;
La figure 2 est une vue schématique de coté d'une partie d'un module thermo électrique comprenant plusieurs ensembles conformes à l'invention, dans laquelle chaque moyen de connexion électrique est relié aux deux éléments thermo électriques par deux premiers éléments indépendants ;
La figure 3 est une vue schématique d'une partie d'un module thermo électrique comprenant deux éléments thermo électriques et un moyen de connexion électrique qui est relié aux deux éléments thermo électriques par un seul premier élément ;
La figure 4 est une vue en perspective représentant un moyen de liaison déformable de l'ensemble selon l'invention ;
Les figures 5a, 5b, 5c, sont des vues de coté de l'ensemble selon l'invention représenté à température ambiante avant brasage (5a) à température de brasage (5b) et à température ambiante après brasage (5c).

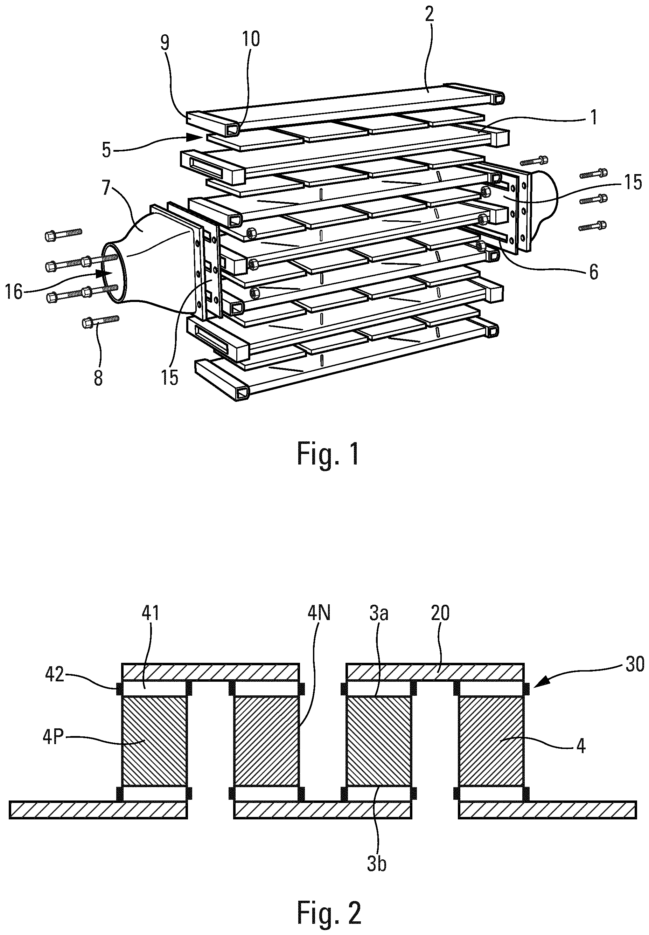

Comme illustré à la figure 1, un dispositif conforme à l'invention comprend des moyens de conduction thermique en contact avec une source chaude ou froide telles qu'une pluralité de tubes 1 de circulation d'un premier fluide alternant avec une pluralité de tubes 2 de circulation d'un deuxième fluide. Lesdits tubes 1, 2 s'étendent ici parallèlement les uns aux autres dans une même direction.

Les tubes 1 de circulation du premier fluide sont configurés, par exemple, pour la circulation d'un fluide, dit chaud. Il pourra s'agir des gaz d'échappement d'un moteur thermique de véhicule automobile. Les tubes 1 de circulation du premier fluide définissent un ou plusieurs canaux de circulation du premier fluide, dits canaux chauds. Les tubes 2 de circulation du deuxième fluide sont configurés, par exemple, pour la circulation d'un fluide, dit froid, présentant une température inférieure à la température du premier fluide. Il pourra s'agir d'un liquide de refroidissement, tel qu'un mélange d'eau et de glycol, provenant, par exemple, d'une boucle de refroidissement basse température du véhicule. Les tubes 2 de circulation du deuxième fluide définissent un ou plusieurs canaux de circulation du deuxième fluide, dits canaux froids.

Ici, les tubes de circulation 1 de gaz d'échappement sont au nombre de trois et les tubes de circulation 2 du liquide de refroidissement sont au nombre de cinq.

Ledit dispositif comprend en outre une pluralité d'éléments, dits thermo électriques, susceptible de créer un courant électrique à partir d'un gradient de température appliqué entre deux de leurs faces, dites première et deuxième faces de contact, prévues en relation d'échange thermique avec lesdits canaux chaud et froid.

Il s'agit, par exemple, d'éléments 4 de forme sensiblement parallélépipédiques (visible de façon schématique aux figures 2, 3 et 4) générant un courant électrique, selon l'effet Seebeck. Selon d'autres modes de réalisation non représentés, la forme des éléments 4 est différente telle que cylindrique. De tels éléments permettent la création d'un courant électrique dans une charge connectée entre lesdites faces de contact 3a, 3b, prévues opposées. De façon connue de l'homme du métier, de tels éléments sont constitués, par exemple, de siliciure de manganèse (MnSi).

Lesdits tubes de circulation 1, 2 présentent, par exemple, une section aplatie selon une direction d'allongement, orthogonale à la direction d'extension des tubes. Lesdits tubes de circulation 1, 2 pourront ainsi être des tubes plats. On entend par là qu'ils présentent deux grandes faces parallèles reliés par des petits côtés. Les éléments thermo électriques 4 sont au contact de l'une et/ou l'autres des faces planes des tubes 1, 2 par leurs faces de contact 3a, 3b.

Lesdits tubes 2 destinés à la circulation du fluide froid sont constitués, par exemple, d'aluminium et/ou d'alliage d'aluminium. Les tubes 1 destinés à la circulation du fluide chaud, sont constitués, notamment, d'acier inox. Ils sont formés, par exemple, par profilage, soudage et/ou brasage.

Ledit dispositif comprend en outre, par exemple, une plaque collectrice 15 à chacune des extrémités desdits tubes 1 de circulation du premier fluide. Ladite plaque collectrice 15 est munie d'orifices 6 dans lesquels les extrémités desdits tubes 1 de circulation du premier fluide sont insérées.

Ledit dispositif pourra également comprendre des boîtes collectrices 7 en communication de fluide avec l'extrémité desdits tubes de circulation 1 du premier fluide et fixées aux plaques collectrices 15 par l'intermédiaire de vis 8. Lesdites boîtes comprennent un orifice 16 pour l'entrée et/ou la sortie du premier fluide.

Lesdits tubes 2 de circulation du second fluide pourront être munis à chacune de leur extrémité de collecteurs 9 permettant une mise en communication desdits tubes 2 de circulation du second fluide et d'une boîte collectrice, non représentée, du deuxième fluide par l'intermédiaire d'orifices 10 débouchant sur une face latérale du faisceau défini par l'empilement des tubes 1, 2 de circulation du premier et du deuxième fluide.

Comme illustré à la figure 1, les éléments thermo électriques sont réparties en nappes 5 prévues entre les tubes 1 de circulation du premier fluide et les tubes 2 de circulation du deuxième fluide. Chaque nappe 5 représente schématiquement une pluralité d'éléments thermo électriques disposés ici selon une forme rectangulaire. Dans le dispositif thermo électrique, des liaisons électriques sont établies entre les nappes 5 d'éléments thermo électriques. Un connecteur électrique, non représenté, permet de relier le dispositif à un circuit électrique extérieur.

Ledit dispositif thermo électrique comprend ici une pluralité de module électrique, chacun des modules électrique étant constitué d'au moins un desdits canal froid et un desdits canal chaud et d'une pluralité desdits éléments thermo électrique 4 situés entre ledit canal froid et ledit canal chaud.

Les éléments thermo électriques 4 pourront être, pour une première partie, des éléments d'un premier type, dit P (référencés 4P sur la figure 2), permettant d'établir une différence de potentiel électrique dans un sens, dit positif, lorsqu'ils sont soumis à un gradient de température donné, et, pour l'autre partie, des éléments d'un second type, dit N (référencés 4N sur la figure 2), permettant la création d'une différence de potentiel électrique dans un sens opposé, dit négatif, lorsqu'ils sont soumis au même gradient de température.

Les éléments thermo électriques appliqués sur un même tube 1, 2 sont reliés électriquement.

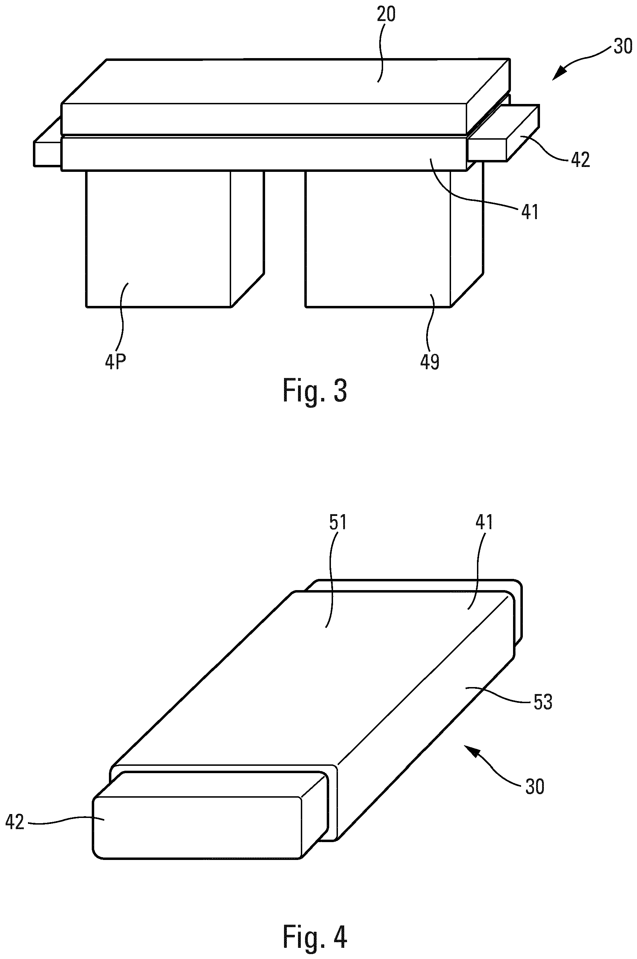

En particulier et comme illustré aux figures 2 et 3, les éléments thermo électriques de type P et les éléments thermo électriques de type N, prévus entre un même tube de circulation du premier fluide et un même tube de circulation du deuxième fluide, pourront être associés entre eux de façon à permettre la circulation du courant en série d'un élément du premier type vers un élément du second type. Il est également possible de relier entre elles par des pistes électriques les faces d'éléments thermo électriques de même types pour un montage en parallèle desdits éléments. Les éléments thermo électriques 4 ainsi associés forment une cellule de conduction de base et les cellules obtenues pourront être associées en série et/ou en parallèle.

Sur ces figures, la première face de contact 3a de chaque éléments thermo électriques est destiné à être en relation d'échange thermique avec le canal chaud et la deuxième face de contact 3b de chaque élément thermo électrique est destinée à être en relation d'échange thermique avec le canal froid.

Les éléments thermo électriques de type P alternent avec les éléments thermo électriques de type N. Ces deux types d'éléments thermo électriques peuvent avoir des coefficients de dilatation différents. Ils sont groupés par paire, chaque paire étant formée d'un élément thermo électrique de type P et d'un élément thermo électrique de type N. On configure ici le module pour permettre une circulation de courant entre les premières faces de contact 3a des éléments thermo électriques d'une même paire et une circulation de courant entre les deuxièmes faces de contact 3b de chacun des éléments thermo électriques de deux paires voisines. Autrement dit, le courant circule en série à travers les éléments thermo électriques en passant alternativement d'un élément thermo électrique de type P à un élément thermo électrique de type N. Pour cela, le module comprend une pluralité de moyens de connexion électrique 20 reliant les premières faces de contact 3a des éléments thermo électriques d'une même paire et les deuxièmes faces de contact 3b de chacun des éléments thermo électriques appartenant à deux paires voisines afin de permettre la circulation de courant décrite précédemment. Deux éléments thermo électriques adjacents sont liés par les moyens de connexion électrique 20 soit par leur première face de contact 3a soit par leur deuxième face de contact 3b. On appelle ensemble 30 selon l'invention, l'association d'au moins un desdits éléments thermo électrique 4 et d'un desdits moyens de connexion électrique 20. Lesdits moyens de connexion électrique 20 pourront aussi relier lesdits éléments thermo électriques en série.

Conformément à l'invention, on peut relier le moyen de connexion 20 à deux éléments thermo électriques 4 par l'intermédiaire d'un unique couple premier élément 41/deuxième élément 42 comme représenté à la figure 3 ou utiliser deux couples premier élément 41/deuxième élément 42 pour relier d'une part le moyen de connexion 20 à un premier élément thermo électrique et d'autre part à un deuxième thermo élément.

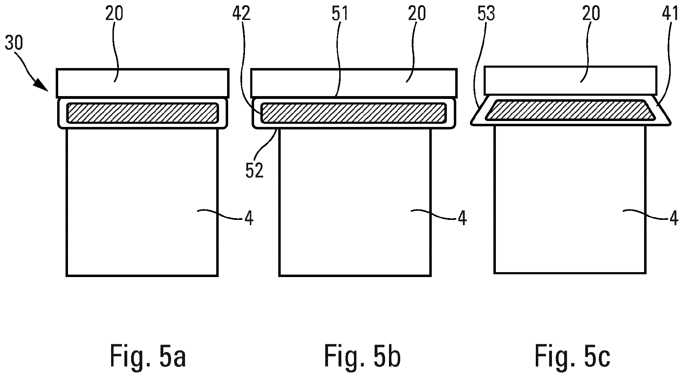

Comme illustré aux figures 4 et 5a à 5c, selon l'invention, l'ensemble 30 comprend un premier élément déformable 41 déformable liant électriquement le moyen de connexion électrique 20 à l'élément thermo électrique 4. Ledit premier élément déformable 41 comprend une première face 51 liée au moyen de connexion électrique 20 et une deuxième face 52 liée à l'élément thermo électrique 4. Ladite première face 51 est déformable indépendamment de ladite deuxième face 52 et inversement. L'ensemble comprend en outre un deuxième élément déformable 42, réalisant un pont thermique entre les première et deuxièmes faces 51, 52 du premier élément déformable 41.

Les moyens de connexion électrique 20 pourront être en contact avec un moyen de conduction thermique, non-illustré, ledit moyen de conduction thermique étant un isolant électrique. Le moyen de conduction thermique est, par exemple, en matériau céramique. Il permet le transfert de chaleur entre le canal froid ou le canal chaud et le moyen de connexion électrique 20 qui transmet alors la chaleur à l'élément thermo électrique 4 sur lequel il se trouve par l'intermédiaire du premier et du deuxième éléments déformable 41, 42.

Le moyen de conduction thermique pourra être directement en contact avec le canal froid ou le canal chaud. Il peut également être en relation d'échange thermique avec le canal froid ou le canal chaud par l'intermédiaire d'ailettes de conduction thermique sur lesquelles il est appliqué.

Le moyen de connexion électrique 20 comprend, notamment, des pistes électriques. Elles sont, par exemple, en Cuivre, alliage de Cuivre, Nickel ou alliage de Nickel. Le moyen de connexion électrique 20 comprend en outre un matériau de brasage, dit brasure, comprenant par exemple, un alliage d'aluminium. Cette brasure est disposée, notamment, au contact des pistes électriques. Elle permet de braser le moyen de connexion 20 à l'élément thermo électrique 4, notamment par l'intermédiaire du premier élément déformable 41. Autrement dit, ledit premier élément déformable 41 est brasé audit élément thermo électriques 4 et/ou audit moyen de connexion électrique 20, notamment par l'intermédiaire d'un placage ou d'une feuille de brasage disposé entre la première face 51 et le moyen de connexion 20 et/ou entre la deuxième face 52 et l'élément thermo électriques 4.

La première face 51 et la deuxième face 52 sont reliées entre elles par deux parois latérales 53. Le premier élément déformable 41 forme ainsi un tube à faces planes, au moins lesdites première et deuxième faces 51, 52 étant planes.

Dans l'exemple représenté, le premier élément déformable 41 de l'invention est une feuille, notamment pliée pour former le tube. Elle présente une épaisseur comprise, par exemple, entre 50 µm et 300 µm. La feuille constituant le premier élément est notamment métallique et en particulier en aluminium ou alliage d'aluminium. Une telle feuille présente notamment l'avantage de pouvoir facilement se déformer localement.

L'invention prévoit également que le premier élément déformable 41 puisse être une grille. La structure de la grille améliore la capacité de déformation locale du premier élément déformable 41.

Le deuxième élément déformable 42 est, par exemple, en graphite. Il s'agit notamment d'une feuille de graphite d'épaisseur inférieure à 1 mm.

Le deuxième élément déformable 42 est situé entre la première face 51 et la deuxième face du premier élément déformable 41, c'est-à-dire qu'il est au contact de la première et de la deuxième face du premier élément déformable 41. Il peut de la sorte établir un pont thermique entre la première face 51 et la deuxième face 52 afin notamment de conduire la chaleur entre le moyen de connexion 20 et le thermo élément 4. Le deuxième élément déformable 42 pourra aussi être au contact des faces latérales 53. Le deuxième élément 42 remplit ici tout l'espace délimité par la première face 51, le deuxième face 52 et les faces latérales 53 du premier élément déformable 41, c'est-à-dire tout l'intérieur du tube formé par le premier élément déformable 41.

Le deuxième élément déformable 42 est déformable plastiquement et/ou élastiquement. Ainsi, comme représenté aux figures 5, il peut suivre les déformations du moyen de connexion 20 et de la première face 51 du premier élément déformable 41 indépendamment des déformations de l'élément thermo électrique 4 et de la deuxième face 52 dudit premier élément 41.

Ces déformations sont par exemple dues aux dilations et contractions que subissent le moyen de connexion 20, l'élément thermo électrique 4 et l'ensemble 30 pendant leur brasage ou en fonctionnement à températures élevées.

Sur la figure 5a, on a représenté l'ensemble de l'invention à température ambiante avant l'opération de brasage. Le moyen de connexion 20, le premier élément déformable 41, le deuxième élément déformable 42 et l'élément thermo électrique 4 sont à leurs dimensions originales.

Sur la figure 5b, l'ensemble 30 est représenté à température de brasage, lors de l'assemblage du moyen de connexion 20 avec les premier et deuxième éléments déformables 41, 42 et l'élément thermo électrique 4. Le moyen de connexion 20, les premier et deuxième éléments déformable 41, 42 et l'élément thermo électrique 4 ont alors chacun subi une dilatation thermique différentes en fonction, notamment, de leurs coefficients de dilatation thermique respectifs. On laisse alors la solidification de l'ensemble intervenir.

La figure 5c représente l'ensemble 30 revenu à température ambiante alors que le moyen de connexion 20 avec le premier élément 41 et l'élément thermo électrique 4 sont brasés ensemble. Le moyen de connexion 20, les premier et deuxième éléments 41, 42 et l'élément thermo électrique 4 ont alors chacun subi une contraction différente en fonction, notamment, de leurs coefficients de dilatation thermique respectifs.

On observe alors que les premier et deuxième éléments déformables 41, 42 se sont déformés de manière à absorber la différence de rétractation entre le moyen de connexion 20 et l'élément thermo électrique 4. Ils permettent ainsi de découpler mécaniquement les déformations du moyen de connexion 20 de celles de l'élément thermo électrique 4. Ainsi, la première face 51 du premier élément déformable 41 a suivi la rétractation du moyen de connexion 20 et la deuxième face 52 du premier élément déformable a suivi la rétractation de l'élément thermo électrique 4. Les parois latérales 53 se sont également déformées, notamment en s'inclinant, pour permettre aux première et deuxième faces 51, 52 de se déformer de manière indépendante.

Lors de cette déformation du premier élément déformable 41, le deuxième élément déformable 42 a suivi cette déformation, en continuant notamment à occupé tout l'intérieur du tube défini par le premier élément déformable 41. Il est donc à même d'assurer une bonne conduction thermique entre les moyens de connexion 20 et l'élément thermo électrique 4.

## Revendications

1. Ensemble (30) d'au moins un élément thermo électrique (4) susceptible de générer un courant électrique sous l'action d'un gradient de température exercé entre deux de ses faces, dites faces de contact (3a, 3b), et d'un moyen de connexion électrique (20), ledit ensemble (30) comprenant en outre un premier élément (41) déformable reliant électriquement le moyen de connexion électrique (20) à l'élément thermo électrique (4), ledit premier élément (41) comprenant une première face (51) liée au moyen de connexion électrique (20) et une deuxième face (52) liée à l'élément thermo électrique (4), ladite première face (51) étant déformable Indépendamment de ladite deuxième face (52) et inversement, l'ensemble comprenant un deuxième élément (42) déformable réalisant un pont thermique entre les première et deuxièmes faces (51, 52) du premier élément (41), **caractérisé en ce que** le premier élément (41) est une grille et les première et deuxième faces (51, 52) du premier élément (41) sont reliées entre elles par deux parois latérales (53) de sorte que le premier élément (41) forme un tube à faces planes (51, 52)

2. Ensemble (30) selon la revendication 1, dans lequel la grille présente une épaisseur comprise entre 50 pm et 300 pm.

3. Ensemble (30) selon l'une quelconque des revendications précédentes, dans lequel le premier élément (41) est en métal.

4. Ensemble (30) selon l'une des revendications précédentes, dans lequel le deuxième élément (42) remplit un volume délimité par la première face (51), la deuxième face (52) et les faces latérales (53) du premier élément.

5. Ensemble (30) selon l'une quelconque des revendications précédentes, dans lequel le deuxième élément (42) est déformable plastiquement.

6. Ensemble (30) selon l'une quelconques des revendications précédentes, dans lequel le deuxième élément (42) est en graphite.

7. Ensemble (30) selon l'une quelconque des revendications précédentes, dans lequel ledit premier élément déformable (41) est brasé audit élément thermo électriques (4) et/ou audit moyen de connexion électrique (20).

8. Ensemble (30) selon l'une quelconque des revendications précédentes, comportant un deuxième élément thermo électrique (4), présentant deux faces de contact (3a, 3b), ladite deuxième face (52) dudit premier élément (41) étant également liée audit deuxième élément thermo électrique (41).

9. Module thermo électrique comprenant une pluralité d'ensembles (30) selon l'une quelconque des revendications précédentes.

10. Dispositif thermo électrique (1), notamment destiné à générer un courant électrique dans un véhicule automobile, comprenant au moins un module selon la revendication précédente.

## Patentansprüche

1. Anordnung (30) aus wenigstens einem thermoelektrischen Element (4), das unter der Einwirkung eines zwischen zwei seiner Flächen, Kontaktflächen (3a, 3b) genannt, angelegten Temperaturgradienten einen elektrischen Strom erzeugen kann, und einem elektrischen Anschlussmittel (20), wobei die Anordnung (30) außerdem ein erstes verformbares Element (41) umfasst, welches das elektrische Anschlussmittel (20) mit dem thermoelektrischen Element (4) elektrisch verbindet, wobei das erste Element (41) eine erste Fläche (51), die mit dem elektrischen Anschlussmittel (20) verbunden ist, und eine zweite Fläche (52), die mit dem thermoelektrischen Element (4) verbunden ist, umfasst, wobei die erste Fläche (51) unabhängig von der zweiten Fläche (52) verformbar ist, und umgekehrt, wobei die Anordnung ein zweites verformbares Element (42) umfasst, das eine thermische Brücke zwischen der ersten und der zweiten Fläche (51, 52) des ersten Elements (41) herstellt,
**dadurch gekennzeichnet, dass** das erste Element (41) ein Gitter ist und die erste und die zweite Fläche (51, 52) des ersten Elements (41) durch zwei Seitenwände (53) miteinander verbunden sind, so dass das erste Element (41) ein Rohr mit ebenen Flächen (51, 52) bildet.

2. Anordnung (30) nach Anspruch 1, wobei das Gitter eine Dicke zwischen 50 pm und 300 pm aufweist.

3. Anordnung (30) nach einem der vorhergehenden Ansprüche, wobei das erste Element (41) aus Metall besteht.

4. Anordnung (30) nach einem der vorhergehenden Ansprüche, wobei das zweite Element (42) ein Volumen füllt, das von der ersten Fläche (51), der zweiten Fläche (52) und den Seitenflächen (53) des ersten Elements begrenzt wird.

5. Anordnung (30) nach einem der vorhergehenden Ansprüche, wobei das zweite Element (42) plastisch verformbar ist.

6. Anordnung (30) nach einem der vorhergehenden Ansprüche, wobei das zweite Element (42) aus Graphit besteht.

7. Anordnung (30) nach einem der vorhergehenden Ansprüche, wobei das erste verformbare Element (41) mit dem thermoelektrischen Element (4) und/oder mit dem elektrischen Anschlussmittel (20) verlötet ist.

8. Anordnung (30) nach einem der vorhergehenden Ansprüche, welche ein zweites thermoelektrisches Element (4) aufweist, das zwei Kontaktflächen (3a, 3b) aufweist, wobei die zweite Fläche (52) des ersten Elements (41) auch mit dem zweiten thermoelektrischen Element (41) verbunden ist.

9. Thermoelektrisches Modul, welches mehrere Anordnungen (30) nach einem der vorhergehenden Ansprüche umfasst.

10. Thermoelektrische Vorrichtung (1), welche insbesondere dazu bestimmt ist, einen elektrischen Strom in einem Kraftfahrzeug zu erzeugen, und mindestens ein Modul nach dem vorhergehenden Anspruch umfasst.

## Claims

1. Assembly (30) of at least one thermoelectric element (4) capable of generating an electric current under the effect of a temperature gradient exerted between two of its sides, referred to as the contact sides (3a, 3b), and an electrical connection means (20), said assembly (30) furthermore including a first deformable element (41) electrically connecting the electrical connection means (20) to the thermoelectric element (4), said first element (41) including a first side (51) linked to the electrical connection means (20) and a second side (52) linked to the thermoelectric element (4), said first side (51) being deformable independently from said second side (52) and vice versa, the assembly including a second deformable element (42) forming a heat bridge between the first and second sides (51, 52) of the first element (41), **characterized in that** the first element (41) is a grid and the first and second sides (51, 52) of the first element (41) are interconnected via two lateral walls (53) in such a way that the first element (41) forms a flat-sided tube (51, 52).

2. Assembly (30) according to Claim 1, in which the grid has a thickness of between 50 pm and 300 pm.

3. Assembly (30) according to either one of the preceding claims, in which the first element (41) is made of metal.

4. Assembly (30) according to one of the preceding claims, in which the second element (42) fills a volume delimited by the first side (51), the second side (52) and the lateral sides (53) of the first element.

5. Assembly (30) according to any one of the preceding claims, in which the second element (42) is plastically deformable.

6. Assembly (30) according to any one of the preceding claims, in which the second element (42) is made of graphite.

7. Assembly (30) according to any one of the preceding claims, in which said first deformable element (41) is soldered to said thermoelectric element (4) and/or to said electrical connection means (20).

8. Assembly (30) according to any one of the preceding claims, including a second thermoelectric element (4), having two contact sides (3a, 3b), said second side (52) of said first element (41) also being linked to said second thermoelectric element (41).

9. Thermoelectric module including a plurality of assemblies (30) according to any one of the preceding claims.

10. Thermoelectric device (1), notably intended to generate an electric current in a motor vehicle, including at least one module according to the preceding claim.
